# FASCICULE DE BREVET EUROPEEN

(11) **EP 3 217 776 B1**
(45) Date de publication et mention de la délivrance du brevet: **08.05.2019**
(21) Numéro de dépôt: 17160618.9
(22) Date de dépôt: 13.03.2017
(51) Int. Cl.: H05K 7/20

(54) **COFFRE DE TRACTION D'UN VEHICULE FERROVIAIRE AVEC SYSTEME DE REFROIDISSEMENT, PROCEDE DE MISE EN OEUVRE ET VEHICULE FERROVIAIRE ASSOCIES**
ZUGKASTEN EINES SCHIENENFAHRZEUGS MIT KÜHLSYSTEM, ENTSPRECHENDES UMSETZUNGSVERFAHREN UND ENTSPRECHENDES SCHIENENFAHRZEUG
TRACTION BOX OF A RAILWAY VEHICLE WITH COOLING SYSTEM, METHOD FOR ITS IMPLEMENTATION AND RAILWAY VEHICLE THEREFOR

(30) Priorité: 11.03.2016 FR 1652083
(43) Date de publication de la demande: 13.09.2017
(73) Titulaire: ALSTOM Transport Technologies, 93400 Saint-Ouen (FR)
(72) Inventeur: AUDEMAR, Christophe, 65310 Horgues (FR)
(74) Mandataire: Lavoix

(56) Documents cités:
- EP-A2- 2 506 695
- US-A1- 2007 051 490

## Description

La présente invention concerne un coffre de traction d'un véhicule ferroviaire, comprenant des premiers et deuxièmes équipements électriques, et un dispositif de refroidissement, propre à évacuer de la chaleur dissipée par lesdits premiers et deuxièmes équipements électriques, le dispositif de refroidissement comprenant : un premier et un deuxième circuits de fluide, traversant respectivement une zone d'échange thermique avec les premiers et avec les deuxièmes équipements électriques, chacun des premier et deuxième circuits de fluide formant une boucle fermée ; et un premier et un deuxième échangeurs de chaleur, traversés respectivement par ledit premier et ledit deuxième circuits de fluide et permettant un échange thermique entre ledit fluide et un premier flux d'air.

L'invention s'applique au domaine du transport ferroviaire, notamment aux véhicules de traction électriques, tels que les locomotives et les automotrices.

Par « coffre de traction », on entend au sens de la présente invention la partie d'un véhicule de traction qui est destinée à commander les moteurs de traction dudit véhicule.

Le dispositif de refroidissement est typiquement destiné à refroidir une partie des équipements électriques tels qu'un module de puissance ou un transformateur, afin d'éviter une surchauffe desdits équipements électriques.

Pour les coffres de traction de puissances élevées, il est difficile de refroidir suffisamment l'ambiante des équipements électriques à l'aide de refroidisseurs tels que des échangeurs de chaleur de type air/air. En effet, outre la chaleur importante dissipée par lesdits équipements, les coffres de traction sont en général installés dans un local technique, dont la température ambiante est augmentée par la présence d'autres appareils électriques.

Il est notamment connu du document US2007/0051490 de refroidir des équipements électriques à l'aide de circuits de fluide réfrigérant, ledit fluide réfrigérant étant lui-même refroidi par un flux d'air extérieur.

En particulier, le document US2007/0051490 met en oeuvre deux circuits distincts de fluide réfrigérant, afin de favoriser le refroidissement de certains équipements électriques par rapport à d'autres.

La présente invention a pour but de proposer un coffre de traction simple à réaliser, tout en permettant de réguler de manière prioritaire le refroidissement de certains équipements électriques dudit coffre.

A cet effet, l'invention a pour objet un coffre de traction du type précité, dans lequel : les premier et deuxième circuits de fluide comprennent un premier conduit commun de circulation de fluide, traversant le premier échangeur de chaleur ; et en sortie dudit premier échangeur de chaleur, ledit premier conduit est relié à un deuxième et un troisième conduits parallèles de circulation de fluide, ledit deuxième conduit appartenant au deuxième circuit de fluide, ledit deuxième conduit traversant d'abord le deuxième échangeur de chaleur puis la zone d'échange thermique avec les deuxièmes équipements électriques.

Suivant d'autres aspects avantageux de l'invention, le coffre de traction comporte l'une ou plusieurs des caractéristiques suivantes, prises isolément ou suivant toutes les combinaisons techniquement possibles :
- le dispositif de refroidissement comprend en outre un dispositif de régulation d'un débit de fluide dans les deuxième et/ou troisième conduits parallèles ;
- le dispositif de régulation et les deuxième et troisième conduits sont configurés pour un débit plus faible dans le deuxième conduit que dans le troisième conduit ;
- la zone d'échange thermique avec les premiers équipements électriques est disposée sur le premier conduit commun de circulation de fluide ;
- la zone d'échange thermique avec les premiers équipements électriques est formée d'au moins deux unités d'échange thermique, disposées en parallèle sur le premier circuit de fluide ;
- le coffre de traction comporte un premier ventilateur apte à générer le premier flux d'air, ledit premier flux d'air traversant les premier et deuxième échangeurs de chaleur ;
- le coffre de traction est configuré de sorte que les premier et deuxième échangeurs de chaleur sont disposés en parallèle dans le premier flux d'air ;
- le coffre de traction comporte un compartiment fermé dans lequel sont situés les premiers et deuxièmes équipements électriques, ledit compartiment fermé étant isolé du premier flux d'air ;
- le dispositif de refroidissement comprend un deuxième ventilateur apte à générer un deuxième flux d'air en direction des deuxièmes équipements électriques, la zone d'échange thermique avec les deuxièmes équipements électriques comprenant un troisième échangeur de chaleur disposé entre le deuxième ventilateur et les deuxièmes équipements électriques, ledit troisième échangeur étant ainsi apte à refroidir le deuxième flux d'air en amont desdits deuxièmes équipements électriques.

L'invention se rapporte en outre à un procédé de mise en oeuvre d'un coffre de traction tel que décrit ci-dessus, comprenant les étapes suivantes : un fluide caloporteur, circulant dans le premier conduit commun, traverse le premier échangeur de chaleur, une température dudit fluide caloporteur diminuant alors par échange thermique avec le premier flux d'air jusqu'à une première valeur en sortie dudit premier échangeur de chaleur ; puis une première partie et une deuxième partie dudit fluide caloporteur circulent respectivement dans le deuxième et le troisième conduits parallèles, la première partie de fluide caloporteur traversant le deuxième échangeur de chaleur, une température dudit fluide caloporteur diminuant alors par échange thermique avec le premier flux d'air jusqu'à une deuxième valeur, ladite première partie de fluide caloporteur traversant ensuite la zone d'échange thermique avec les deuxièmes équipements électriques ; et le fluide caloporteur, ou la deuxième partie du fluide caloporteur, à une température supérieure à la deuxième valeur, traverse la zone d'échange thermique avec les premiers équipements électriques.

L'invention se rapporte en outre à un véhicule ferroviaire comportant au moins un moteur de traction commandé par un coffre de traction tel que décrit ci-dessus.

L'invention sera mieux comprise à la lecture de la description qui va suivre, donnée uniquement à titre d'exemple non limitatif et faite en se référant aux dessins sur lesquels :
- la figure 1 est une vue schématique d'un coffre de traction selon un mode de réalisation de l'invention ; et
- la figure 2 est une vue schématique d'un module électronique de régulation du coffre de traction de la figure 1.

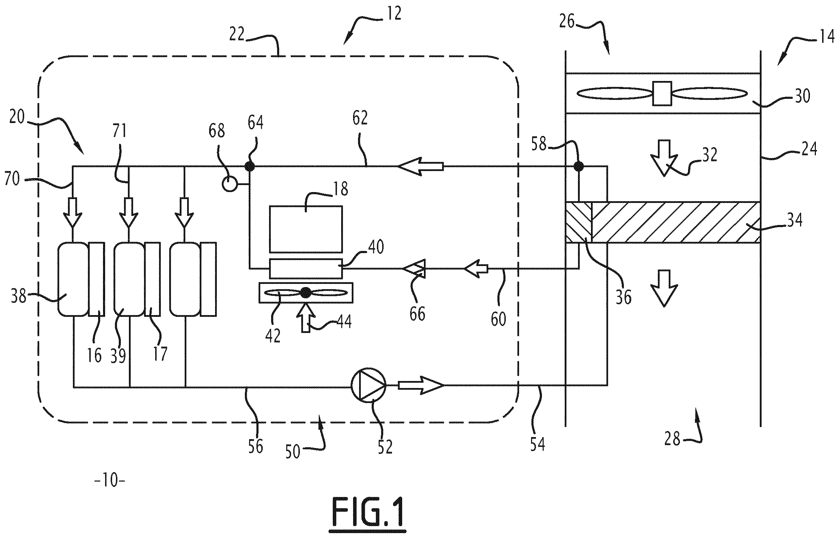

La figure 1 représente une vue schématique de face d'un coffre de traction 10 d'un véhicule ferroviaire, selon un mode de réalisation de l'invention.

Le coffre 10 comporte un compartiment fermé 12 et une colonne de ventilation 14. Le coffre 10 comporte également des premiers équipements électriques 16, 17 et un deuxième équipement électrique 18, disposés dans le compartiment fermé 12.

Le coffre 10 comporte en outre un dispositif de refroidissement 20, propre à évacuer de la chaleur dissipée, en particulier dans le compartiment fermé 12, par lesdits premiers 16, 17 et deuxième 18 équipements électriques.

Le dispositif de refroidissement 20 est disposé dans le compartiment fermé 12 et dans la colonne de ventilation 14.

Le compartiment fermé 12 est défini par une enveloppe 22, représentée en pointillés sur la figure 1. De préférence, l'enveloppe 22 est étanche à l'air. Ainsi, l'air présent à l'intérieur de ladite enveloppe 22 est confiné dans le compartiment fermé 12.

Le deuxième équipement électrique 18 comprend de préférence des éléments dont le maintien à une température appropriée est essentiel au fonctionnement du coffre de traction 10. Dans le mode de réalisation représenté à la figure 1, le deuxième équipement électrique 18 est une unité de commande de moteurs de traction du véhicule ferroviaire.

Les premiers équipements électriques 16, 17 comprennent de préférence des éléments dont le maintien à une température appropriée est moins prioritaire pour le fonctionnement du coffre de traction 10 que celui du deuxième équipement électrique 18. Les premiers équipements électriques 16, 17 comprennent par exemple des circuits de traitement d'un courant électrique provenant d'une source d'énergie électrique externe au véhicule ferroviaire, telle qu'une caténaire.

La colonne de ventilation 14 comporte un conduit de ventilation 24 qui traverse le coffre de traction 10, par exemple verticalement. Le conduit 24 comporte une entrée d'air 26 et une sortie d'air 28, lesdites entrée et sortie débouchant à l'extérieur du coffre 10.

La colonne de ventilation 14 comporte en outre un premier ventilateur 30, apte à générer un flux d'air extérieur 32 entre l'entrée 26 et la sortie 28 du conduit de ventilation 24.

Le dispositif de refroidissement 20 comprend un premier échangeur thermique 34 et un deuxième échangeur thermique 36, disposés dans le conduit de ventilation 24. Les premier 34 et deuxième 36 échangeurs thermiques sont de type air/fluide, de préférence air/liquide. Par exemple, les premier 34 et deuxième 36 échangeurs thermiques sont des radiateurs à ailettes ou des échangeurs de chaleur de type plaque et barrette.

De préférence, une puissance du premier échangeur thermique 34 est significativement supérieure à une puissance du deuxième échangeur thermique 36. En particulier, une surface d'échange thermique du premier échangeur thermique 34 est significativement supérieure à une surface d'échange thermique du deuxième échangeur thermique 36. Par exemple, un ratio des surfaces d'échange thermique entre le deuxième 36 et le premier 34 échangeurs thermiques est compris entre 5% et 10%.

De préférence, les premier 34 et deuxième 36 échangeurs thermiques sont disposés en parallèle dans le conduit de ventilation 24. Ainsi, le flux d'air extérieur 32 comprend deux parties dont chacune traverse un seul desdits premier 34 et deuxième 36 échangeurs. Lesdits premier 34 et deuxième 36 échangeurs sont préférentiellement réalisés de manière monobloc et disposés par exemple horizontalement, côte à côte, dans le conduit 24.

Le dispositif de refroidissement 20 comprend en outre des troisièmes échangeurs thermiques 38, 39, aptes à dissiper de la chaleur générée par les premiers équipements électriques 16, 17. Lesdits troisièmes échangeurs thermiques sont disposés dans le compartiment fermé 12. Comme décrit ci-dessous, chacun des troisièmes échangeurs thermiques 38, 39 est apte à être traversé par un circuit de fluide caloporteur.

Chacun des troisièmes échangeurs thermiques 38, 39 est par exemple un radiateur ou un refroidisseur de type plaque à eau, en contact thermique avec l'un des premiers équipements électriques 16, 17, de sorte à dissiper par conduction, dans le circuit d'eau, la chaleur émise par ledit équipement électrique.

Les troisièmes échangeurs thermiques 38, 39 définissent une zone d'échange thermique avec les premiers équipements électriques 16, 17.

Dans le mode de réalisation représenté à la figure 1, le coffre 10 comporte plusieurs troisièmes échangeurs thermiques 38, 39. En variante non représentée, le coffre 10 comporte un unique troisième échangeur thermique, équipant l'un des premiers équipements électriques 16, 17.

Le dispositif de refroidissement 20 comprend en outre un quatrième échangeur thermique 40, disposé dans le compartiment fermé 12. Ledit quatrième échangeur thermique 40 est apte à être traversé par un circuit de fluide caloporteur.

Le quatrième échangeur thermique 40 est apte à dissiper de la chaleur générée par le deuxième équipement électrique 18. Ledit quatrième échangeur thermique 40 permet en outre de refroidir l'ambiante du coffre 10 en transférant des calories de l'air ambiant vers le circuit d'eau.

Le quatrième échangeur thermique 40 définit une zone d'échange thermique avec le deuxième équipement électrique 18.

Dans le mode de réalisation représenté à la figure 1, le quatrième échangeur thermique 40 est de type air/fluide, de préférence air/liquide. En variante non représentée, le quatrième échangeur thermique 40 est un radiateur en contact thermique avec le deuxième équipement électrique 18.

Dans le mode de réalisation représenté à la figure 1, le dispositif de refroidissement 20 comprend en outre un deuxième ventilateur 42, disposé dans le compartiment fermé 12. Le deuxième ventilateur 42 est apte à générer un flux d'air intérieur 44 entre le quatrième échangeur thermique 40 et le deuxième équipement électrique 18.

En variante non représentée, le coffre 10 comporte plusieurs quatrièmes échangeurs thermiques, équipant plusieurs deuxièmes équipements électriques tels que définis précédemment.

Le dispositif de refroidissement 20 comprend en outre un circuit 50 de fluide caloporteur. Le circuit 50 est un circuit fermé, interne au coffre de traction 10. Le circuit 50 est apte à faire circuler un fluide caloporteur entre le compartiment fermé 12 et la colonne de ventilation 14.

Le circuit 50 comporte notamment une pompe de circulation 52, apte à mettre en mouvement le fluide caloporteur selon un sens de circulation. Le fluide caloporteur est de préférence un liquide, par exemple de l'eau mélangée à un additif tel que l'éthylène glycol.

Le circuit 50 comporte un premier conduit de fluide 54 défini entre une entrée 56 et une sortie 58. Le premier échangeur thermique 34 est disposé sur le premier conduit 54. Dans le mode de réalisation de la figure 1, la pompe de circulation 52 est également disposée sur le premier conduit 54.

Au niveau de la sortie 58, le circuit 50 se subdivise en un deuxième 60 et un troisième 62 conduits disposés en parallèle. Lesdits deuxième 60 et troisième 62 conduits se rejoignent en un point de collecte 64.

Le deuxième conduit 60 passe successivement par le deuxième échangeur thermique 36, situé dans la colonne de ventilation 14, puis par le quatrième échangeur thermique 40, situé dans le compartiment fermé 12, avant de rejoindre le point de collecte 64.

Le circuit 50 comporte un dispositif 66 de régulation d'un ratio de débits de fluide caloporteur entre le deuxième 60 et le troisième 62 conduits. De préférence, le dispositif de régulation 66 et les deuxième 60 et troisième 62 conduits sont configurés pour un débit plus faible dans le deuxième conduit 60 que dans le troisième conduit 62.

Dans le mode de réalisation représenté à la figure 1, le dispositif de régulation 66 est un dispositif de type diaphragme situé sur le deuxième conduit 60. Le diaphragme 66 impose un ratio fixe de débits de fluide caloporteur entre le deuxième 60 et le troisième 62 conduits.

Selon une variante non représentée, le dispositif de régulation 66 est un dispositif de type vanne trois voies, situé en sortie 58 du premier conduit de fluide 54, permettant de faire varier le ratio de débits.

Préférentiellement, le circuit 50 comporte en outre une ou plusieurs sondes 68 de température du fluide caloporteur. La ou lesdites sondes sont par exemple situées sur le deuxième conduit 60, en amont et/ou en aval du quatrième échangeur thermique 40. De préférence, la sonde est positionnée immédiatement en aval du point de collecte 64, pour contrôler la température en entrée des troisièmes échangeurs thermiques 38, 39. Dans le mode de réalisation de la figure 1, entre le point de collecte 64 et l'entrée 56 du premier conduit 54, le circuit 50 comporte une pluralité de branches 70, 71 disposées en parallèles. Chacune des branches parallèles 70, 71 traverse l'un des troisièmes échangeurs thermiques 38, 39 associés aux premiers équipements électriques 16, 17.

Selon une variante non représentée, les branches parallèles 70, 71, traversant les troisièmes échangeurs thermiques 38, 39, forment une partie du troisième conduit 62 en amont du point de collecte 64.

Selon une autre variante non représentée, les troisièmes échangeurs thermiques 38, 39, ou certains desdits troisièmes échangeurs thermiques 38, 39, sont disposés en série sur le circuit 50.

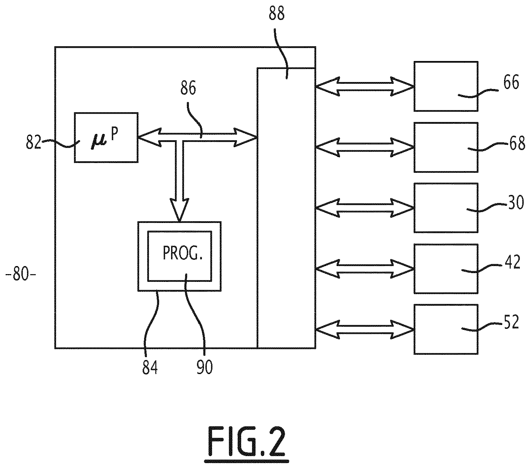

Selon un mode de réalisation de l'invention, le coffre 10 de la figure 1 comprend en outre un module électronique de régulation 80, schématiquement représenté à la figure 2. Selon ledit mode de réalisation, le dispositif de régulation 66 est de type électrovanne, apte à faire varier le débit entre deuxième 60 et le troisième 62 conduits.

Le module électronique 80 comprend notamment un microprocesseur 82, une mémoire 84 de programme et au moins un bus 86 de communication. Par une interface 88, le module 80 est relié à la ou aux sondes de température 68, au dispositif de régulation 66 et éventuellement à la pompe de circulation 52 et/ou au premier 30 et/ou au deuxième 42 ventilateurs.

Un programme 90 est mémorisé dans la mémoire 84. Le programme 90 est notamment apte à régler le dispositif de régulation 66 de débit de fluide caloporteur dans le deuxième conduit 60, en fonction d'une température, ou d'une différence de températures, mesurée par la ou les sondes 68. Eventuellement, le programme 90 est également apte à contrôler un fonctionnement de la pompe de circulation 52, et/ou de régler une vitesse de rotation du premier 30 et/ou du deuxième 42 ventilateurs.

Selon un autre mode de réalisation de l'invention, le coffre 10 de la figure 1 ne comporte pas d'électronique de régulation, en particulier dans le cas où le dispositif de régulation 66 est un dispositif fixe de type diaphragme.

Un procédé de fonctionnement du coffre de traction 10 va maintenant être décrit. Le fonctionnement des premiers 16, 17 et deuxième 18 équipements électriques conduit à une augmentation de température desdits équipements électriques, renforcée par leur confinement dans le compartiment fermé 12.

Afin d'éviter une surchauffe desdits équipements électriques, le flux d'air extérieur 32 généré par le premier ventilateur 30 refroidit le fluide caloporteur qui traverse le premier échangeur thermique 34. On considère qu'en sortie 58 dudit premier échangeur thermique 34, le fluide caloporteur est à une première température T₁. Ladite première température T₁ est ici supérieure à une température du flux d'air extérieur 32 en entrée 26 du conduit d'air 24.

En aval de la sortie 58, le fluide caloporteur est réparti entre les deuxième 60 et troisième 62 conduits, par le dispositif de régulation 66. Le fluide circulant dans le deuxième conduit 60 traverse le deuxième échangeur thermique 36. De préférence, le débit de fluide traversant le deuxième échangeur 36 est significativement inférieur au débit de fluide traversant le premier échangeur 34 ; un ratio des débits de fluide entre le deuxième 36 et le premier 34 échangeurs thermiques est notamment compris entre 3% et 10%. Par exemple, le débit dans le deuxième conduit 60 est de 10 L/mn et le débit dans le troisième conduit 62 est de 210 L/mn.

De manière favorisée par ce faible débit, la température du fluide caloporteur en sortie du deuxième échangeur thermique 36 atteint une valeur T₂ inférieure à T₁.

Le fluide caloporteur circulant dans le deuxième conduit 60 traverse ensuite le quatrième échangeur thermique 40 et refroidit le flux d'air intérieur 44 avant que ledit flux d'air n'arrive au contact du deuxième équipement électrique 18. Ledit flux d'air intérieur 44, ainsi refroidi, est plus efficace pour refroidir par convection ledit deuxième équipement électrique 18.

Le fluide caloporteur du deuxième conduit 60, à la température T₂ la plus faible, est donc utilisé pour refroidir l'équipement électrique 18 considéré comme prioritaire dans le coffre 10.

En aval du quatrième échangeur thermique 40, le fluide caloporteur des deuxième 60 et troisième 62 conduits est rassemblé au point de collecte 64. Ledit fluide traverse ensuite les troisièmes échangeurs thermiques 38, 39, pour refroidir les premiers équipements électriques 16, 17 considérés comme moins prioritaires. En entrée desdits troisièmes échangeurs thermiques 38, 39, la température du fluide caloporteur est notamment supérieure à T₂.

En sortie des troisièmes échangeurs thermiques 38, 39, le fluide caloporteur est rassemblé à l'entrée 56 du premier conduit 54, pour rejoindre le premier échangeur thermique 34.

De manière optionnelle, l'aménagement intérieur du compartiment fermé 12 est configuré de sorte que le flux d'air intérieur 44 circule autour des premiers équipements électriques 16, 17 après avoir refroidi le deuxième équipement électrique 18. Le flux d'air intérieur 44 contribue ainsi à refroidir par convection lesdits premiers équipements électriques 16, 17.

Selon un mode de réalisation de l'invention, le procédé de fonctionnement décrit ci-dessus est mis en oeuvre par le programme 90 du module électronique 80 décrit ci-dessus. De manière optionnelle, en fonction de la ou des températures mesurées par la ou les sondes de température 68, le programme 90 modifie en temps réel le réglage du dispositif de régulation 66, et/ou le débit de la pompe 52, et/ou la vitesse du premier 30 et/ou du deuxième 42 ventilateurs.

Le coffre de traction 10 tel que décrit ci-dessus peut être réalisé par des adaptations faciles à mettre en oeuvre sur des coffres de traction existants, comprenant un compartiment fermé 12 et une colonne de ventilation 14. Par exemple, les premier 34 et deuxième 36 échangeurs thermiques peuvent être réalisés de manière monobloc, ce qui facilite leur installation dans le conduit de ventilation 24.

## Revendications

1. Coffre de traction (10) d'un véhicule ferroviaire, comprenant :
- des premiers (16, 17) et deuxièmes (18) équipements électriques, et
- un dispositif de refroidissement (20), propre à évacuer de la chaleur dissipée par lesdits premiers et deuxièmes équipements électriques,
le dispositif de refroidissement comprenant :
- une première (38, 39) et une deuxième (40) zones d'échange thermique, aptes à dissiper de la chaleur générée respectivement par les premiers (16, 17) et par les deuxièmes (18) équipements électriques ;
- un premier (54, 62, 70, 71) et un deuxième (54, 60, 70, 71) circuits de fluide, traversant respectivement la première (38, 39) et la deuxième (40) zones d'échange thermique, chacun des premier et deuxième circuits de fluide formant une boucle fermée ; et
- un premier (34) et un deuxième (36) échangeurs de chaleur, traversés respectivement par ledit premier (54) et ledit deuxième (60) circuits de fluide et permettant un échange thermique entre ledit fluide et un premier flux d'air (32),
le coffre de traction étant **caractérisé en ce que** :
- les premier et deuxième circuits de fluide comprennent un premier conduit commun (70, 71, 54) de circulation de fluide, traversant le premier échangeur de chaleur (34) ; et
- en sortie (58) dudit premier échangeur de chaleur, ledit premier conduit est relié à un deuxième (60) et un troisième (62) conduits parallèles de circulation de fluide, ledit deuxième conduit (60) appartenant au deuxième circuit de fluide, ledit deuxième conduit traversant d'abord le deuxième échangeur de chaleur (36) puis la deuxième zone d'échange thermique (40).

2. Coffre de traction selon la revendication 1, dans lequel le dispositif de refroidissement (20) comprend en outre un dispositif (66) de régulation d'un débit de fluide dans les deuxième (60) et/ou troisième (62) conduits parallèles.

3. Coffre de traction selon la revendication 2, dans lequel le dispositif de régulation (66) et les deuxième (60) et troisième (62) conduits sont configurés pour un débit plus faible dans le deuxième conduit (60) que dans le troisième conduit (62).

4. Coffre de traction selon l'une des revendications précédentes, dans lequel la première zone d'échange thermique (38, 39) est disposée sur le premier conduit commun (70, 71) de circulation de fluide.

5. Coffre de traction selon l'une des revendications précédentes, dans lequel la première zone d'échange thermique est formée d'au moins deux unités d'échange thermique (38, 39), disposées en parallèle (70, 71) sur le premier circuit de fluide.

6. Coffre de traction selon l'une des revendications précédentes, comportant un premier ventilateur (30) apte à générer le premier flux d'air (32), ledit premier flux d'air traversant les premier (34) et deuxième (36) échangeurs de chaleur.

7. Coffre de traction selon la revendication 6, configuré de sorte que les premier (34) et deuxième (36) échangeurs de chaleur sont disposés en parallèle dans le premier flux d'air (32).

8. Coffre de traction selon la revendication 6 ou la revendication 7, comportant un compartiment fermé (12) dans lequel sont situés les premiers (16, 17) et deuxièmes (18) équipements électriques, ledit compartiment fermé étant isolé du premier flux d'air (32).

9. Coffre de traction selon l'une des revendications précédentes, dans lequel le dispositif de refroidissement comprend un deuxième ventilateur (42) apte à générer un deuxième flux d'air (44) en direction des deuxièmes équipements électriques (18),
la deuxième zone d'échange thermique comprenant un troisième échangeur de chaleur (40) disposé entre le deuxième ventilateur et les deuxièmes équipements électriques (18), ledit troisième échangeur étant ainsi apte à refroidir le deuxième flux d'air en amont desdits deuxièmes équipements électriques.

10. Procédé de mise en oeuvre d'un coffre de traction (10) selon l'une des revendications précédentes, comprenant les étapes suivantes :
- un fluide caloporteur circulant dans le premier conduit commun (54) traverse le premier échangeur de chaleur (34), une température dudit fluide caloporteur diminuant alors par échange thermique avec le premier flux d'air (32) jusqu'à une première valeur (T₁) en sortie (58) dudit premier échangeur de chaleur ; puis
- une première partie et une deuxième partie dudit fluide caloporteur circulent respectivement dans le deuxième (60) et le troisième (62) conduits parallèles,
la première partie de fluide caloporteur traversant le deuxième échangeur de chaleur (36), une température dudit fluide caloporteur diminuant alors par échange thermique avec le premier flux d'air (32) jusqu'à une deuxième valeur (T₂), ladite première partie de fluide caloporteur traversant ensuite la zone (40) d'échange thermique avec les deuxièmes équipements électriques (18) ;
et
- le fluide caloporteur, ou la deuxième partie du fluide caloporteur, à une température supérieure à la deuxième valeur (T₂), traverse la zone (38, 39) d'échange thermique avec les premiers équipements électriques (16, 17).

11. Véhicule ferroviaire comportant au moins un moteur de traction commandé par un coffre de traction (10) selon l'une quelconque des revendications 1 à 9.

## Patentansprüche

1. Antriebsbox (10) eines Schienenfahrzeugs, aufweisend:
- erste (16, 17) und zweite (18) elektrische Einrichtungen, und
- eine Kühlungs-Vorrichtung (20), die imstande ist, die Wärme, die von den ersten und den zweiten elektrischen Einrichtungen dissipiert wird, abzuführen,
wobei die Kühlungs-Vorrichtung aufweist:
- einen ersten (38, 39) und einen zweiten (40) Wärmetauschbereich, die imstande sind, die von den ersten (16, 17) und den zweiten (18) elektrischen Einrichtungen respektive erzeugte Wärme zu dissipieren,
- einen ersten (54, 62, 70, 71) und einen zweiten (54, 60, 70, 71) Fluidkreis, die respektive den ersten (38, 39) und den zweiten (40) Wärmetauschbereich durchqueren, wobei jeder von dem ersten und dem zweiten Fluidkreis eine geschlossene Schleife bildet, und
- einen ersten (34) und einen zweiten (36) Wärmetauscher, die respektive von dem ersten (54) und dem zweiten (60) Fluidkreis durchquert werden und einen Wärmetausch zwischen dem besagten Fluid und einem ersten Luftstrom (32) erlauben,
wobei die Antriebsbox **dadurch gekennzeichnet ist, dass**:
- der erste und der zweite Fluidkreis eine gemeinsame erste Fluidzirkulations-Leitung (70, 71, 54) aufweisen, die den ersten Wärmetauscher (34) durchquert, und
- am Ausgang (58) des besagten ersten Wärmetauschers die besagte erste Leitung mit einer zweiten (60) und einer dritten (62) Fluidzirkulations-Leitung, die parallel sind, verbunden ist, wobei die zweite Leitung (60) dem zweiten Fluidkreis zugehört, wobei die zweite Leitung zunächst den zweiten Wärmetauscher (36) und dann den zweiten Wärmetauschbereich (40) durchquert.

2. Antriebsbox gemäß Anspruch 1, wobei die Kühlungs-Vorrichtung (20) ferner aufweist eine Vorrichtung (66) zur Regulierung eines Fluid-Durchflussstroms in der zweiten (60) und/oder der dritten Leitung (62), die parallel sind.

3. Antriebsbox gemäß Anspruch 2, wobei die Regulierungs-Vorrichtung (66) und die zweite (60) und die dritte (62) Leitung konfiguriert sind für einen Durchflussstrom, der in der zweiten Leitung (60) kleiner ist als in der dritten Leitung (62).

4. Antriebsbox gemäß einem der vorhergehenden Ansprüche, wobei der erste Wärmetauschbereich (38, 39) an der gemeinsamen ersten Fluidzirkulations-Leitung (70, 71) angeordnet ist.

5. Antriebsbox gemäß irgendeinem der vorhergehenden Ansprüche, wobei der erste Wärmeaustauschbereich von wenigstens zwei Wärmetauscheinheiten (38, 39) gebildet, die parallel (70, 71) in dem ersten Fluidkreis angeordnet sind.

6. Antriebsbox gemäß einem der vorhergehenden Ansprüche, aufweisend ein erstes Gebläse(30), das imstande ist, den ersten Luftstrom (32) zu generieren, wobei der erste Luftstrom den ersten (34) und den zweiten (36) Wärmetauscher durchquert.

7. Antriebsbox gemäß Anspruch 6, die derart konfiguriert ist, dass der erste (34) und der zweite (36) Wärmetauscher parallel in dem ersten Luftstrom (32) angeordnet sind.

8. Antriebsbox gemäß Anspruch 6 oder Anspruch 7, aufweisend ein geschlossenes Abteil (12), in welchem die ersten (16, 17) und die zweiten (18) elektrischen Einrichtungen angeordnet sind, wobei das geschlossene Abteil von dem ersten Luftstrom (32) isoliert ist.

9. Antriebsbox gemäß einem der vorhergehenden Ansprüche, wobei die Kühlungs-Vorrichtung aufweist ein zweites Gebläse (42), das imstande ist, einen zweiten Luftstrom (44) zu erzeugen in Richtung der zweiten elektrischen Einrichtungen (18), wobei der zweite Wärmetauschbereich einen dritten Wärmetauscher (40) aufweist, der zwischen dem zweiten Gebläse und den zweiten elektrischen Einrichtungen (18) angeordnet ist, wobei der dritte Tauscher daher imstande ist, den zweiten Luftstrom stromaufwärts der zweiten elektrischen Einrichtungen zu kühlen.

10. Verfahren zum Betreiben einer Antriebsbox (10) gemäß einem der vorhergehenden Ansprüche, aufweisend die folgenden Schritte:
- ein Kühlfluid, das in der gemeinsamen ersten Leitung (54) zirkuliert, durchquert den ersten Wärmetauscher (34), wobei sich dann eine Temperatur des besagten Kühlfluid verringert durch Wärmetausch mit dem ersten Luftstrom (32) bis auf einen ersten Wert (T₁) am Ausgang (58) des ersten Wärmetauschers,
- dann ein erster Teil und ein zweiter Teil des Kühlfluid zirkulieren respektive in der zweiten (60) und der dritten (62) Leitung, die parallel sind,
wobei der erste Teil Kühlfluid den zweiten Wärmetauscher (36) durchquert, wobei eine Temperatur des besagten Kühlfluid dann abnimmt durch Wärmetausch mit dem ersten Luftstrom (32) bis auf einen zweiten Wert (T₂), wobei der erste Teil Kühlfluid danach den Wärmetauschbereich (40) mit den zweiten elektrischen Einrichtungen (18) durchquert,
und
- das Kühlfluid, oder der zweite Teil des Kühlfluid, mit einer Temperatur, die größer als der zweite Wert (T2) ist, durchquert den Wärmetauschbereich (38, 39) mit den ersten elektrischen Einrichtungen (16, 17).

11. Schienenfahrzeug mit wenigstens einem Antriebsmotor, der mittels einer Antriebsbox (10) gemäß irgendeinem der Ansprüche 1 bis 9 betrieben ist.

## Claims

1. The traction box (10) of a railway vehicle, comprising:
- first (16, 17) and second (18) pieces of electric equipment, and
- a cooling device (20), able to remove heat dissipated by said first and second pieces of electric equipment,
the cooling device comprising:
- a first (38, 39) and a second (40) heat exchange areas, able to dissipate heat generated respectively by the first (16, 17) and second (18) pieces of electric equipment;
- first (54, 62, 70, 71) and second (54, 60, 70, 71) fluid circuits, respectively crossing the first (38, 39) and the second (40) heat exchange areas, each of the first and second fluid circuits forming a closed loop; and
- a first (34) and a second (36) heat exchangers, respectively crossed by said first (54) and said second (60) fluid circuits and allowing a heat exchange between said fluid and a first air flow (32),
wherein:
- the first and second fluid circuits comprise a first common conduit (70, 71, 54) for fluid circulation, crossing the first heat exchanger (34); and
- at the outlet (58) of said first heat exchanger, said first conduit is connected to a second (60) and a third (62) conduits parallel to the circulation of fluid, said second conduit (60) belonging to the second fluid circuit, said second conduit first crossing the second heat exchanger (36) and then the second heat exchange area (40).

2. The traction box according to claim 1, wherein the cooling device (20) further comprises a device (66) for regulating a fluid flow rate in the second (60) and/or third (62) parallel conduits.

3. The traction box according to claim 2, wherein the regulation device (66) and the second (60) and third (62) conduits are configured for a lower flow rate in the second conduit (60) than in the third conduit (62).

4. The traction box according to claim 1, wherein the first heat exchange area (38, 39) is positioned on the first common conduit (70, 71) for fluid circulation.

5. The traction box according to claim 1, wherein the first heat exchange area is formed with at least two heat exchange units (38, 39), positioned in parallel (70, 71) on the first fluid circuit.

6. The traction box according to claim 1 , including a first fan (30) able to generate the first air flow (32), said first air flow crossing the first (34) and second (36) heat exchangers.

7. The traction box according to claim 6, configured so that the first (34) and second (36) heat exchangers are positioned in parallel in the first air flow (32).

8. The traction box according to claim 6 or claim 7, including a closed compartment (12) wherein are located the first (16, 17) and second (18) pieces of electric equipment, said closed compartment being isolated from the first air flow (32).

9. The traction box according to claim 1 , wherein the cooling device comprises a second fan (42) able to generate a second air flow (44) towards the second pieces of electric equipment (18),
the second heat exchange area comprising a third heat exchanger (40) positioned between the second fan and the second pieces of electric equipment (18), said third exchanger thus being able to cool the second air flow upstream from said second pieces of electric equipment.

10. A method for applying a traction box (10) according to claim 1, comprising the following steps:
- a heat transfer fluid circulating in the first common conduit (54) crosses the first heat exchanger (34), a temperature of said heat transfer fluid then reducing by heat exchange with the first air flow (32) as far as a first value (T₁) at the outlet (58) of said first heat exchanger; and then
- a first portion and a second portion of said heat transfer fluid respectively circulate in the second (60) and third (62) parallel conduits,
the first portion of heat transfer fluid crossing the second heat exchanger (36), a temperature of said heat transfer fluid then being reduced by heat exchange with the first air flow (32) down to a second value (T₂), said first heat transfer fluid portion then crossing the heat exchange area (40) with the second pieces of electric equipment (18);
and
- the heat transfer fluid, or the second portion of the heat transfer fluid, at a temperature greater than the second value (T₂), crosses the heat exchange area (38, 39) with the first pieces of electric equipment (16, 17).

11. A railway vehicle including at least one traction motor controlled by a traction box (10) according to claim 1.
